# EUROPEAN PATENT APPLICATION

(11) **EP 2 843 754 A1**
(43) Date of publication of application: **04.03.2015**
(21) Application number: 13781376.2
(22) Date of filing: 09.04.2013
(51) Int. Cl.: H01M 14/00, H01L 31/04

(54) **PHOTOELECTRIC CONVERSION ELEMENT MODULE AND METHOD FOR MANUFACTURING SAME**

(30) Priority: 23.04.2012 JP 2012097605
(71) Applicant: Sharp Kabushiki Kaisha, Osaka-shi, Osaka 545-8522 (JP)
(72) Inventor: KOMIYA, Ryoichi, Osaka-shi, Osaka 545-8522 (JP); FUKUI, Atsushi, Osaka-shi, Osaka 545-8522 (JP); YAMANAKA, Ryohsuke, Osaka-shi, Osaka 545-8522 (JP)
(74) Representative: Müller - Hoffmann & Partner
(86) International application number: PCT/JP2013/060667
(87) International publication number: WO 2013/161557

(57) **Abstract**

Provided is a photoelectric conversion element module where it is possible to suppress influence of deterioration of individual photoelectric conversion elements on the entire module.

A photoelectric conversion element module (100) is provided with a plurality of photoelectric conversion elements (1) which are connected in series, and separation layers (3) which separate the adjacent photoelectric conversion elements (1) in a parallel direction. The photoelectric conversion elements (1) include a light transmitting substrate and a support substrate which are arranged to oppose each other. The photoelectric conversion elements (1) further include a conductive film layer, a photoelectric conversion layer where a photosensitizing agent is adsorbed on the surface, a catalyst layer, a counter conductive layer, and a carrier transporting layer which is formed of a carrier transporting material, which are arranged between the light transmitting substrate and the support substrate. The photoelectric conversion elements (1) further include a sealing agent which fixes the support substrate to the light transmitting substrate. Pores are formed in the separation layers (3).

## Description

### Technical Field

The present invention relates to a photoelectric conversion element module and a method for manufacturing the same.

### Background Art

Solar batteries which convert sunlight into electricity have attracted attention as an energy source to replace fossil fuels. Currently, solar batteries using crystalline silicon substrates and thin-film silicon solar batteries are being put into practical use. However, in the solar batteries using crystalline silicon substrates, there is a problem in that the manufacturing costs of the silicon substrates are high. In the thin-film silicon solar batteries, there is a problem in that the manufacturing costs are high since it is necessary to use various types of gases for semiconductor manufacturing and complex apparatuses. For this reason, efforts to reduce the costs of the electric power output by increasing the efficiency of photoelectric conversion are continuing for all solar batteries; however, the problems described above have not been solved.

In addition, a photoelectric conversion element which applies photo-induced electron movement of a metal complex has been proposed as a new type of solar battery (for example, refer to PTL 1). The photoelectric conversion element has a structure where a photoelectric conversion layer, which adsorbs a photosensitizing coloring dye thereon so as to have an absorption spectrum in the visible light region, and an electrolytic solution are interposed between electrodes on two glass substrates where the electrodes (a first electrode and a second electrode) are formed on the surface. In the photoelectric conversion element, when light is received by the transparent first electrode side, a phenomenon occurs where electrons are generated in the photoelectric conversion layer, the generated electrons move from one first electrode to the opposing second electrode by passing through an external electric circuit, and the moved electrons are carried by ions in the electrolytic solution so as to return to the photoelectric conversion layer. It is possible to produce electrical energy by repeating such electron movement in series.

A photoelectric conversion element module where photoelectric conversion elements are connected in series has been proposed as a form for implementing such a photoelectric conversion element (for example, refer to PTL 2). This has an advantage in that it is difficult to decrease the fill factor even when the area of the module is increased since connection is carried out in a state where the movement distance of the electrons of the photoelectric conversion elements configuring the above is short.

### Citation List

### Patent Literature

PTL 1: Japan Patent Publication "Japanese Unexamined Patent Application Publication No. 1-220380 (published September 4th, 1989)"
PTL 2: Pamphlet of International Publication WO. 97/16838 (published May 9th, 1997)"

### Summary of Invention

### Technical Problem

However, there is a problem in the photoelectric conversion element modules which are connected in series in that the power generation efficiency of the photoelectric conversion element module as a whole is greatly decreased if even one of the connected photoelectric conversion elements deteriorates. In addition, when the photoelectric conversion elements which are connected in series are divided a plurality of times and set to a form of being connected in parallel, the performance decrease in the photoelectric conversion element module as a whole is limited; however, there is a problem in that the manufacturing process is complicated since it is necessary to form a carrier transporting layer for all of the photoelectric conversion elements which are in series-parallel.

The present invention was made in consideration of the problem described above and has a main object of providing a photoelectric conversion element module where it is possible to suppress the influence of deterioration of individual photoelectric conversion elements on the module as a whole. In addition, another object of the present invention is to provide a method for manufacturing a photoelectric conversion element module where it is possible to easily manufacture the photoelectric conversion element module.

### Solution to Problem

As a result of intensive research to solve the problem described above, the present inventors found that in a photoelectric conversion element module, by dividing the photoelectric conversion elements which configure the module using separation layers which have pores, it is possible to easily manufacture a photoelectric conversion element module having such functions while suppressing the influence of the deterioration of the photoelectric conversion elements due to the influence of reverse current or the like on the module as a whole, thereby completing the present invention.

That is, a photoelectric conversion element module according to the present invention is provided with a plurality of photoelectric conversion elements which are connected in series, and separation layers which separate the adjacent photoelectric conversion elements in a parallel direction. The photoelectric conversion elements include a light transmitting substrate and a support substrate. The light transmitting substrate and the support substrate are arranged to oppose each other. The photoelectric conversion elements further include a conductive film layer, a photoelectric conversion layer where a photosensitizing agent is adsorbed on a surface, a catalyst layer, a counter conductive layer, and a carrier transporting layer which is formed of a carrier transporting material. The conductive film layer, the photoelectric conversion layer, the catalyst layer, the counter conductive layer, and the carrier transporting layer are arranged between the light transmitting substrate and the support substrate. The photoelectric conversion elements further include a sealing agent which fixes the support substrate to the light transmitting substrate. Pores are formed in the separation layers.

In the photoelectric conversion element module described above, the separation layers may be formed from a material whose pores are closed due to an external load.

In the photoelectric conversion element module described above, the separation layers may be bonded with the light transmitting substrate and the support substrate.

In the photoelectric conversion element module described above, in at least one or more photoelectric conversion elements, introduction holes for introducing the carrier transporting material need not be formed in either of the light transmitting substrate and the support substrate.

In the photoelectric conversion element module described above, the photoelectric conversion elements may include a porous insulation layer which is provided between the conductive film layer and the counter conductive layer.

A method for manufacturing a photoelectric conversion element module according to the present invention is for manufacturing a photoelectric conversion element module of any of the aspects described above and includes a step of forming a separation layer where pores are formed, and a step of forming a carrier transporting layer by introducing a carrier transporting material via the separation layer.

### Advantageous Effects of Invention

According to the photoelectric conversion element module of the present invention, it is possible to suppress the influence of the deterioration of the individual photoelectric conversion elements on the module as a whole since the constituent photoelectric conversion elements are separated by separation layers which have pores.

### Brief Description of Drawings

[Fig. 1] Fig. 1 is an upper section diagram which schematically shows an example of a structure of a photoelectric conversion element module of an aspect of the present embodiment.
[Fig. 2] Fig. 2 is a cross-sectional diagram of the photoelectric conversion element module along line II-II shown in Fig. 1.
[Fig. 3] Fig. 3 is a cross-sectional diagram which shows an example of a structure of a photoelectric conversion element which configures the photoelectric conversion element module of an aspect of the present embodiment.
[Fig. 4] Fig. 4 is a cross-sectional diagram which shows a different cross-section of the photoelectric conversion element shown in Fig. 3.
[Fig. 5] Fig. 5 is a cross-sectional diagram which shows another example of a structure of a photoelectric conversion element.
[Fig. 6] Fig. 6 is a cross-sectional diagram which shows a different cross-section of the photoelectric conversion element shown in Fig. 5.
[Fig. 7] Fig. 7 is a cross-sectional diagram which illustrates a first example of a structure of a separation layer.
[Fig. 8] Fig. 8 is a cross-sectional diagram which illustrates a second example of the structure of the separation layer.
[Fig. 9] Fig. 9 is a cross-sectional diagram which illustrates a third example of the structure of the separation layer.

### Description of Embodiments

Below, description will be given of embodiments of the present invention based on the drawings. Here, in the following drawings, the same reference numerals are given for the same or equivalent portions and description thereof will not be repeated.

### <Photoelectric Conversion Element>

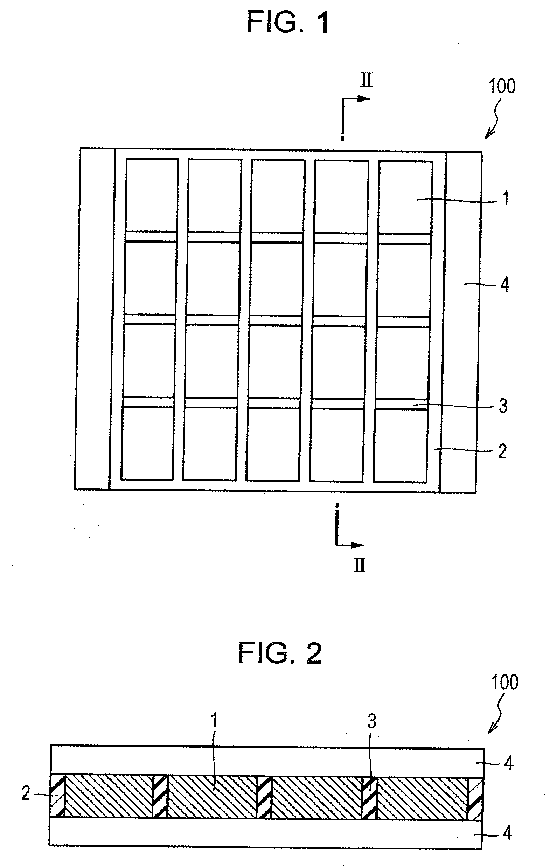

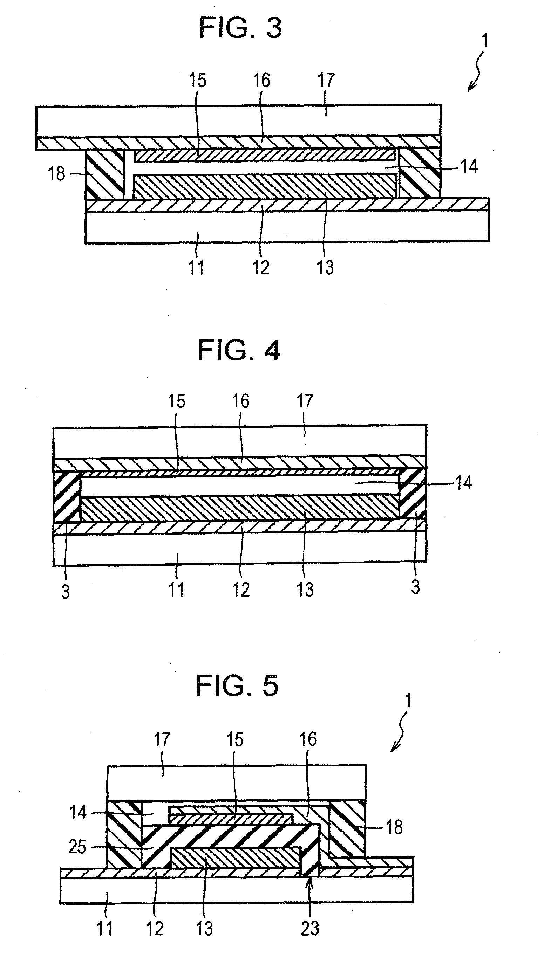

First, description will be given of a configuration example of a photoelectric conversion element 1 according to the present embodiment with reference to the drawings. Fig. 1 is an upper section diagram which schematically shows an example of a structure of a photoelectric conversion element module 100 of the present embodiment. Fig. 2 is a cross-sectional diagram of the photoelectric conversion element module 100 along a line II-II shown in Fig. 1. The photoelectric conversion element module 100 shown in Fig. 1 and Fig. 2 is provided with a plurality of photoelectric conversion elements 1, a sealing section 2, a separation layer 3 which has pores, and a collecting electrode 4. The photoelectric conversion element module 100 is formed by connecting at least two or more of the photoelectric conversion elements 1 in series. The sealing section 2 separates charge transporting layers of the photoelectric conversion elements 1 which are connected in series. Here, "in series" indicates that photoelectric conversion elements 1 which line up in the left and right direction in Fig. 1 are connected with each other. The up and down direction in Fig. 1 is referred to as a parallel direction which is a direction which intersects with a series direction. It is possible to use the photoelectric conversion element 1 with a configuration as shown in Fig. 3 to Fig. 6 as the photoelectric conversion element 1.

Fig. 3 is a cross-sectional diagram which shows an example of a structure of the photoelectric conversion element 1 which configures the photoelectric conversion element module 100 of the present embodiment. Fig. 4 is a cross-sectional diagram which shows a different cross-section of the photoelectric conversion element 1 shown in Fig. 3. For one of the photoelectric conversion elements 1 which are included in the photoelectric conversion element module 100 shown in Fig. 1, Fig. 3 shows a cross-sectional diagram along the left and right direction (the series direction) in Fig. 1 and Fig. 4 illustrates a cross-sectional diagram along the up and down direction (the parallel direction) in Fig. 1. The photoelectric conversion element 1 shown in Fig. 3 and Fig. 4 includes a light transmitting substrate 11, a conductive film layer 12, a photoelectric conversion layer 13 where a photosensitizing agent is adsorbed on the surface, a carrier transporting layer 14 which is formed of a carrier transporting material, a catalyst layer 15, a counter conductive layer 16, a support substrate 17, and a sealing agent 18.

The light transmitting substrate 11 and the support substrate 17 are arranged so as to oppose each other. The conductive film layer 12, the photoelectric conversion layer 13, the catalyst layer 15, the counter conductive layer 16, and the carrier transporting layer 14 are arranged between the light transmitting substrate 11 and the support substrate 17. The carrier transporting material is filled into spaces in each of the photoelectric conversion layer 13 where the photosensitizing agent is adsorbed and the catalyst layer 15. The sealing agent 18 fixes the support substrate 17 to the light transmitting substrate 11.

In a case where the photoelectric conversion element 1 shown in Fig. 3 and Fig. 4 is used and connected in series, it is also possible to use a module in a form which is laminated and formed by alternately forming the photoelectric conversion layer 13 and the catalyst layer 15 on the same substrate. That is, the photoelectric conversion element module 100 may be formed by forming the photoelectric conversion layer 13 on the light transmitting substrate 11 and forming the catalyst layer 15 on the support substrate 17 in one photoelectric conversion element 1, and forming the photoelectric conversion layer 13 on the support substrate 17 and forming the catalyst layer 15 on the light transmitting substrate 11 in another photoelectric conversion element 1 which is adjacent to the one photoelectric conversion element 1.

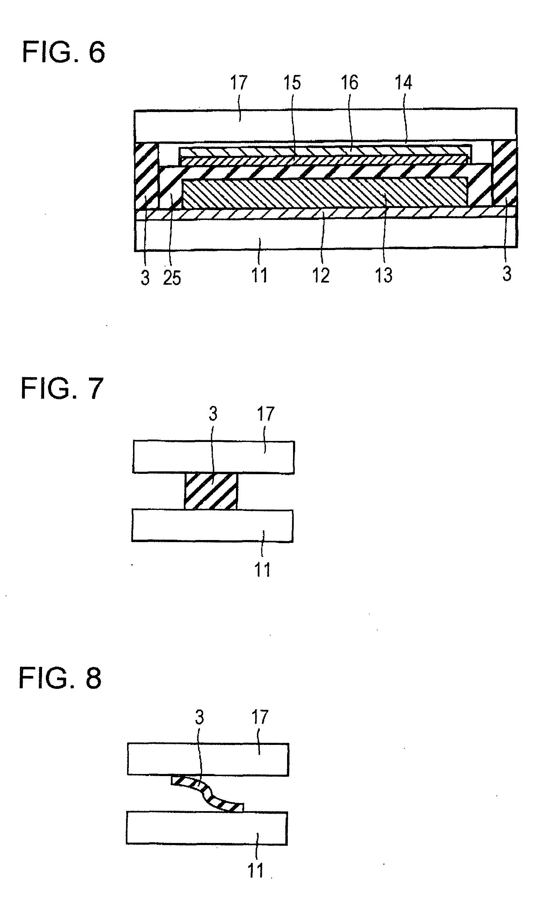

Fig. 5 is a cross-sectional diagram which shows another example of a structure of the photoelectric conversion element 1. Fig. 6 is a cross-sectional diagram which shows a different cross-section of the photoelectric conversion element 1 shown in Fig. 5. For one of the photoelectric conversion elements 1 which are included in the photoelectric conversion element module 100 shown in Fig. 1, Fig. 5 shows a cross-sectional diagram along the left and right direction in Fig. 1 and Fig. 6 illustrates a cross-sectional diagram along the up and down direction in Fig. 1. In the same manner as the photoelectric conversion element 1 shown in Fig. 3 and Fig. 4, the photoelectric conversion element 1 shown in Fig. 5 and Fig. 6 includes the light transmitting substrate 11 and the support substrate 17 which oppose each other, and the conductive film layer 12, the photoelectric conversion layer 13, the carrier transporting layer 14, the catalyst layer 15, the counter conductive layer 16, and the sealing agent 18, which are arranged between the light transmitting substrate 11 and the support substrate 17.

The photoelectric conversion element 1 shown in Fig. 5 and Fig. 6 also includes a porous insulation layer 25 which is provided between the conductive film layer 12 and the counter conductive layer 16. A scribe line 23 is formed on the conductive film layer 12. The conductive film layer 12 is divided by providing the porous insulation layer 25 inside the scribe line 23. The carrier transporting material is filled into each of the spaces in the photoelectric conversion layer 13 where the photosensitizing agent is adsorbed, the porous insulation layer 25, and the catalyst layer 15. Detailed description will be given below of each of the sections which configure the photoelectric conversion element 1 of the present embodiment.

### <Light transmitting substrate 11>

Since it is necessary for the light transmitting substrate 11 to have a light transmitting property in at least a portion which is a light receiving surface, it is necessary for the light transmitting substrate 11 to be formed of a material with a light transmitting property. However, it is not always necessary to have a transmitting property with respect to light in all wavelength regions as long as the material is able to substantially transmit light with a wavelength to which at least the coloring dye has effective sensitivity, which will be described below. In addition, the light transmitting substrate 11 preferably has a thickness of approximately 0.2 mm to 5 mm.

That is, the material which configures the light transmitting substrate 11 is not particularly limited as long as the material is able to be used in a typical solar battery and is able to exhibit the effects of the present invention. Examples of such a material include glass substrates such as soda-lime glass, fused quartz glass, and crystal quartz glass, and heat resistant resin plates such as a flexible film.

Examples of the materials which configure the flexible films (referred to below as "films") include tetraacetyl cellulose (TAC), polyethylene terephthalate (PET), polyphenylene sulfide (PPS), polycarbonate (PC), polyarylate (PA), polyethylimide (PEI), phenoxy resin, Teflon (registered trademark), and the like.

In a case where another member is formed on the light transmitting substrate 11 by heating, for example, in a case where the photoelectric conversion layer 13 formed of a porous semiconductor is formed on the light transmitting substrate 11 by heating at approximately 250°C, Teflon (registered trademark) which has a heat resistance to temperatures of 250°C or more is particularly preferable. In addition, it is possible to use the light transmitting substrate 11 as a base when attaching the completed photoelectric conversion element module 100 to another structural body. That is, it is possible to easily attach a peripheral section of the light transmitting substrate 11 such as a glass substrate to another structural body using a metal processed component and a screw.

### <Conductive Film Layer 12>

The material which configures the conductive film layer 12 may be any material which functions as a collecting electrode. In a case of being arranged further to the light receiving surface side than the porous semiconductor layer, a material which transmits light is preferable; however, it is not always necessary to have a transmitting property with respect to light in all wavelength regions as long as the material is able to substantially transmit light with a wavelength to which at least the coloring dye has effective sensitivity, which will be described below. Examples of such materials include indium tin oxide (ITO), tin oxide (SnO₂), tin oxide doped with fluorine (FTO), zinc oxide (ZnO), titanium oxide doped with tantalum or niobium, and the like.

It is possible to form the conductive film layer 12 on the light transmitting substrate 11 using a method known in the art such as a sputtering method or a spray method. The film thickness of the conductive film layer 12 is approximately 0.02 µm to 5 µm and the film resistance thereof is preferably as low as possible, and preferably 40 Ω/sq or less.

Using a light transmitting conductive substrate where FTO as the conductive film layer 12 is laminated on soda-lime float glass as the light transmitting substrate 11 is particularly preferable, and commercial products of light transmitting conductive substrates may be used.

### <Support Substrate 17>

The support substrate 17 may be any substrate as long as it is possible to hold the carrier transporting material and it is possible to prevent water or the like from permeating from outside. However, in a case where the support substrate 17 is a light receiving surface, it is necessary to have the same light transmitting property as the light transmitting substrate 11. Accordingly, it is possible to form the support substrate 17 using, for example, the same material as the light transmitting substrate 11. In particular, in consideration of outdoor installations or the like, it is possible to favorably use strengthened glass or the like.

Here, the support substrate 17 (in a case where the catalyst layer 15 and the counter conductive layer 16 are formed on the surface thereof, these are also included) preferably does not contact the laminated body which is formed on the light transmitting substrate 11. Due to this, it is possible to form the carrier transporting layer 14 and it is possible to hold a sufficient amount of the carrier transporting material inside the photoelectric conversion element 1. In addition, in a case where an introduction port for the carrier transporting material is formed in a part of the support substrate 17 and the carrier transporting material is introduced using a vacuum introduction method, a vacuum impregnation method, or the like, the introduction speed of the carrier transporting material is increased by the support substrate 17 not coming into contact with the laminated body which is formed on the light transmitting substrate 11. Accordingly, it is possible to improve the tact time for the manufacturing of the photoelectric conversion element 1 and the photoelectric conversion element module 100.

### <Photoelectric Conversion Layer 13>

The photoelectric conversion layer 13 is formed of a porous semiconductor layer where the photosensitizing agent is adsorbed, and the carrier transporting material is able to move inside and outside the photoelectric conversion layer 13. Below, description will be given of each of the porous semiconductor layer and the photosensitizing agent.

### (Porous Semiconductor Layer)

The types of semiconductors which configure the porous semiconductor layer are not particularly limited as long as the semiconductor is used in a typical photoelectric conversion material in this field. Examples thereof include semiconductor compounds such as titanium oxide, zinc oxide, tin oxide, iron oxide, niobium oxide, cerium oxide, tungsten oxide, barium titanate, strontium titanate, cadmium sulfide, lead sulfide, zinc sulfide, indium phosphide, copper-indium sulfide (CuInS₂), CuAlO₂, and SrCu₂O₂, or combinations thereof. Among these, titanium oxide is particularly preferable from the point of view of stability and safety.

As the titanium oxide which is favorably used in the porous semiconductor layer, there are various types of titanium oxide, titanium hydroxide, and hydroxylated titanium in the strict sense such as anatase type titanium oxide, rutile type titanium oxide, amorphous titanium oxide, metatitanic acid, and orthotitanic acid, and it is possible to use these alone or in a mixture. It is possible for the titanium oxide to take the form of either of two types of crystalline titanium oxide, anatase type or rutile type, according to the manufacturing method and thermal history thereof; however, the anatase type is typical. In the present embodiment, with regard to the coloring dye sensitivity, titanium oxide with a high content of an anatase type, for example, 80% or more, is particularly preferable.

The form of the semiconductor may be single crystal or polycrystal; however, from the point of view of stability, ease of crystal growth, manufacturing costs, and the like, polycrystal is preferable, and the form of semiconductor fine particles (from nano to micro scale) formed of polycrystal is particularly preferable. Accordingly, it is particularly preferable to use fine particles of titanium oxide as the material of the porous semiconductor layer. It is possible for the fine particles of titanium oxide to be manufactured using a method known in the art such as a gas-phase method, or a liquid phase method (a hydrothermal synthesis method or a sulfuric acid method). In addition, there are also methods for obtaining the particles by high-temperature hydrolysis of chloride developed by Evonik Degussa GmbH.

In addition, mixtures of fine particles with two or more particle sizes formed of the same or different semiconductor compounds may be used as the semiconductor fine particles. It is considered that semiconductor fine particles with a large particle size scatter incident light and contribute to an increase in the light capture ratio and semiconductor fine particles with a small particle size contribute to an increase in the adsorption amount of the coloring dye by further increasing the adsorption points.

The ratio of the average particle diameter of the different particle sizes is preferably 10 times or more with the average particle diameter of the semiconductor fine particles with a large particle size suitably being approximately 100 nm to 500 nm, and the average particle diameter of the semiconductor fine particles with a small particle size suitably being approximately 5 nm to 50 nm. In a case of mixed particles formed of different semiconductor compounds, it is effective to set a semiconductor compound with a strong adsorption action as the semiconductor particles with a small particle size.

The film thickness of the porous semiconductor layer is not particularly limited; however, for example, approximately 0.1 µm to 100 µm is suitable. In addition, the porous semiconductor layer preferably has a large surface area and, as the surface area, for example, approximately 10 m²/g to 200 m²/g is preferable. Here, the film thickness of the porous semiconductor layer, that is, the film thickness of the photoelectric conversion layer 13, is preferably the same as the height of the separation layer 3 as the inter-cell insulation section.

### (Method for Forming Porous Semiconductor Layer)

The method for forming the porous semiconductor layer is not particularly limited and examples thereof include methods known in the art. Examples thereof include a method where a suspension which contains the semiconductor fine particles described above is applied to a support body and at least one of drying and firing is performed.

In detail, first, a suspension is obtained by suspending semiconductor fine particles in a suitable solvent. Examples of such solvents include glyme solvents such as ethylene glycol monomethyl ether, alcohols such as isopropyl alcohol, alcohol-based mixed solvents such as isopropyl alcohol/toluene, water, and the like. In addition, commercially available titanium oxide paste may be used instead of the suspension (for example, Ti-nanoxide T, D, T/SP, and D/SP, manufactured by Solaronix SA.).

Next, the obtained suspension is applied to the support body and a porous semiconductor layer is formed on the support body by performing at least one of drying and firing. As the coating method, it is possible to use a method which is known in the art such as a doctor blade method, a squeegee method, a spin coating method, or a screen printing method.

The temperature, time, atmosphere, and the like which are necessary in the drying and firing may be appropriately set according to the type of the semiconductor fine particles, for example, it is possible to perform the drying and firing for approximately 10 seconds to 12 hours in a range of approximately 50°C to 800°C under an air atmosphere or an inert gas atmosphere. The drying and firing may be performed one time at a single temperature or two or more times after changing the temperature.

The porous semiconductor layer may be a plurality of layers. In such a case, the steps of preparing the suspension of the different semiconductor fine particles, and performing the coating and at least one of the drying and firing may be repeated two or more times. In addition, after forming the porous semiconductor layer, post processing may be performed with the object of improving performance such as improving the electrical connection between the semiconductor fine particles, increasing the surface area of the porous semiconductor layer, reducing the level of defects in the semiconductor fine particles, and the like. For example, in a case where the porous semiconductor layer is a titanium oxide film, it is possible to improve the performance of the porous semiconductor layer by carrying out treatment with a titanium tetrachloride aqueous solution.

### (Photosensitizing Agent)

Examples of the photosensitizing agent which is adsorbed on the porous semiconductor layer include various types of organic coloring dyes, metal complex coloring dyes, and the like having absorption in the visible light region or the infrared region, and it is possible to selectively use one type or two or more types of these coloring dyes.

Examples of the organic coloring dyes include azo dyes, quinone dyes, quinoneimine dyes, quinacridone dyes, squarylium dyes, cyanine dyes, merocyanine dyes, triphenylmethane dyes, xanthene dyes, porphyrin dyes, perylene dyes, indigo dyes, naphthalocyanine dyes, and the like. The extinction coefficient of the organic coloring dye is generally large in comparison with metal complex coloring dyes which take a form where the molecule is coordinated and bonded with a transition metal.

The metal complex dyes are dyes where a metal is coordinated and bonded with the molecule. Examples of the molecule include porphyrin dyes, phthalocyanine dyes, naphthalocyanine dyes, ruthenium dyes, and the like. Examples of the metal include Cu, Ni, Fe, Co, V, Sn, Si, Ti, Ge, Cr, Zn, Ru, Mg, Al, Pb, Mn, In, Mo, Y, Zr, Nb, Sb, La, W, Pt, Ta, Ir, Pd, Os, Ga, Tb, Eu, Rb, Bi, Se, As, Sc, Ag, Cd, Hf, Re, Au, Ac, Tc, Te, Rh, and the like. Among these, ones where the metal is coordinated with a phthalocyanine dye, or a ruthenium dye are preferable and ruthenium metal complex dyes are particularly preferable.

In particular, ruthenium metal complex dyes which are represented by the following formulas (1) to (3) are preferable. Examples of commercially available ruthenium metal complex dyes include Ruthenium 535 dye, Ruthenium 535-bis TBA dye, Ruthenium 620-1H3TBA dye, and the like, which are trade names manufactured by Solaronix SA.

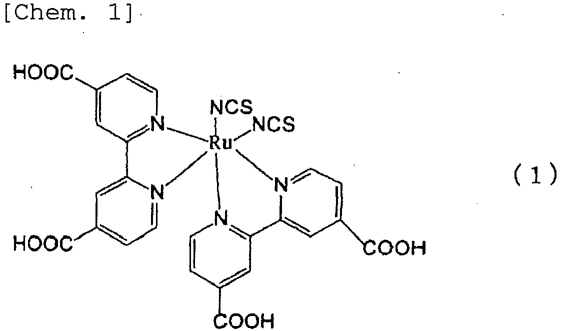

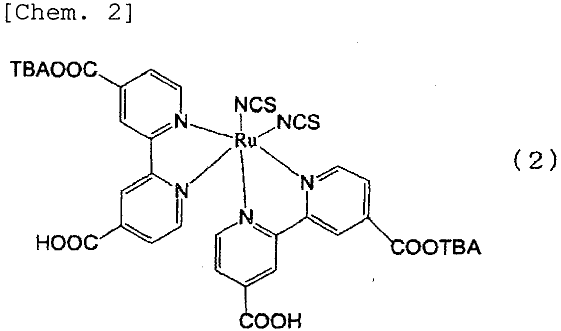

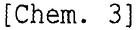

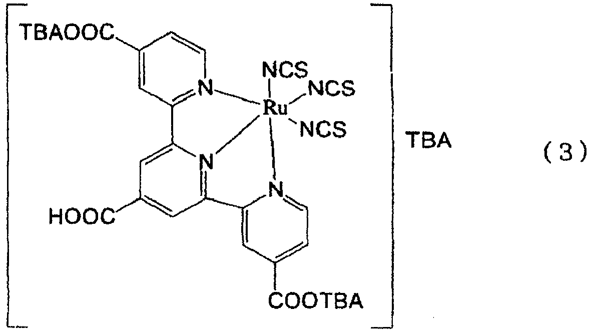

In addition, in order to firmly adsorb the coloring dye on the porous semiconductor layer, it is preferable to have an interlocking group such as a carboxyl group, an alkoxy group, a hydroxyl group, a sulfonic acid group, an ester group, a mercapto group, or a phosphonyl group in the coloring dye molecule. Here, the interlocking group is generally interposed when the coloring dye is fixed to the porous semiconductor layer and provides an electrical bond which facilitates the movement of electrons between the coloring dye in an excited state and the conduction band of the semiconductor.

### (Method for Adsorbing Photosensitizing Agent)

Examples of the method for adsorbing the coloring dye described above on the porous semiconductor layer include a method for immersing the porous semiconductor layer in a solvent where the coloring dye is dissolved (coloring dye adsorption solution). At this time, the coloring dye adsorption solution may be heated in order for the coloring dye adsorption solution to permeate up to the inner parts of the fine pores in the porous semiconductor layer.

The solvent which dissolves the coloring dye may be any solvent which dissolves the coloring dye and examples thereof include alcohol, toluene, acetonitrile, tetrahydrofuran (THF), chloroform, dimethyl formamide, and the like. These solvents are preferably purified, and two or more types may be used as a mixture. It is possible to appropriately set the concentration of the coloring dye in the coloring dye adsorption solution according to the conditions such as the coloring dye to be used, the type of solvent, and the coloring dye adsorption step; however, a high concentration is preferable in order to improve the adsorption function, for example, 1×10⁻⁵ mol/L or more is preferable. In the preparation of the coloring dye adsorption solution, heating may be carried out in order to improve the solubility of the coloring dye.

### <Catalyst Layer 15>

The catalyst layer 15 may be any layer as long as it is a material which is able to transfer electrons on the surface thereof and specific examples thereof include noble metal materials such as platinum and palladium, and carbon based materials such as carbon black, Ketjen black, carbon nanotubes, and fullerene.

### <Counter conductive layer 16>

The counter conductive layer 16 is not particularly limited as long as it has conductivity and the counter conductive layer 16 may or may not have a light transmitting property. However, in a case where the support substrate 17 is a light receiving surface, it is necessary to have the same light transmitting property as the transparent conductive layer.

Examples of the material which configures the counter conductive layer 16 include indium tin oxide (ITO), tin oxide (SnO₂), material where fluorine is doped into tin oxide (FTO), zinc oxide (ZnO), and the like. In addition, metals which do not exhibit corrosion with respect to the electrolytic solution may be used, such as titanium, nickel, and tantalum. It is possible to form the counter conductive layer formed of such material using a method known in the art such as a sputtering method or a spray method.

The film thickness of the counter conductive layer 16 is suitably approximately 0.02 µm to 5 µm and the film resistance is preferably as low as possible, and particularly preferably 40 Ω/sq or less. In addition, in a case where the counter conductive layer 16 has a dense structure in the photoelectric conversion element 1 as shown in Fig. 5 and Fig. 6, it is preferable to form a plurality of small holes for the carrier transporting material path in order to facilitate the adsorption of the photosensitizing agent and the introduction of carrier transporting material.

It is possible to form the small holes described above by physical contact or laser processing with respect to the counter conductive layer 16. The size of the small holes is preferably approximately 0.1 µm to 100 µm and more preferably approximately 1 µm to 50 µm. The intervals between the small holes are preferably approximately 1 µm to 200 µm, and more preferably approximately 10 µm to 300 µm. In addition, it is also possible to obtain the same effects by forming stripe shaped opening sections in the conductive film layer 12. The intervals of the stripe shaped opening sections are preferably approximately 1 µm to 200 µm and more preferably 10 µm to 300 µm.

### <Porous Insulation Layer 25>

Examples of the material which configures the porous insulation layer 25 include silicon oxides such as niobium oxide, zirconium oxide, silica glass, and soda-lime glass, aluminum oxide, barium titanate, and the like and it is possible to selectively use one type or two or more types of these materials. In addition, it is possible to suitably use titanium oxide with a particle diameter of 100 nm to 500 nm, and rutile type titanium oxide. These materials are preferably in the form of particles and the average particle diameter thereof is 5 nm to 500 nm, preferably 10 nm to 300 nm.

It is possible to form the porous insulation layer 25 using the same method as the photoelectric conversion layer 13 described above. That is, an insulation material in the fine particle form described above is dispersed in a suitable solvent, a polymer compound of ethylcellulose, polyethylene glycol (PEG), or the like is further mixed therewith to obtain a paste, the obtained paste is applied, and at least one of drying and firing is performed. Due to this, it is possible to easily form the porous insulation layer 25 with a porous property.

### <Carrier transporting layer 14>

As shown in Fig. 3 and Fig. 5, the carrier transporting layer 14 is a region, which is surrounded by the light transmitting substrate 11, the support substrate 17, and the sealing agent 18, and where the carrier transporting material is introduced, and is formed by interposing a void or the porous insulation layer 25 between each of the substrates. The carrier transporting material which is introduced into the carrier transporting layer 14 is a conductive material which is able to transport ions, and examples of favorable materials include liquid electrolytes, solid electrolytes, gel electrolytes, molten salt gel electrolytes, and the like.

The liquid electrolytes may be any liquid material which includes a redox species, and is not particularly limited as long as it is possible for the material to be used in typical batteries, solar batteries, and the like. In detail, examples include materials formed of a redox species and a solvent which is able to dissolve the redox species, materials formed of a redox species and a molten salt which is able to dissolve the redox species, and materials formed of a redox species and a solvent or a molten salt which is able to dissolve the redox species.

Examples of the redox species include I⁻/I³⁻based redox species, Br²⁻/Br³⁻based redox species, Fe²⁺/Fe³⁺ based redox species, quinone/hydroquinone based redox species, and the like. In detail, combinations of iodines and metal iodides (I₂) such as lithium iodide (LiI), sodium iodide (NaI), potassium iodide (KI), and calcium iodide (CaI₂), combinations of iodines and tetraalkyl ammonium salt such as tetraethyl ammonium iodide (TEAI), tetrapropylammonium iodide (TPAI), tetrabutylammonium iodide (TBAI), and tetrahexyl ammonium iodide (THAI), and combinations of bromines and metal bromides such as lithium bromide (LiBr), sodium bromide (NaBr), potassium bromide (KBr), and calcium bromide (CaBr₂) are preferable, and out of these, combinations of LiI and I₂ are particularly preferable.

In addition, examples of the solvents of the redox species include carbonate compounds such as propylene carbonate, nitrile compounds such as acetonitrile, alcohols such as ethanol, water, aprotic polar substances, and the like. Among these, carbonate compounds and nitrile compounds are particularly preferable. It is possible for these solvents to be used as a mixture of two or more types.

The solid electrolytes may be any electrolytes of a conductive material which is able to transport electrons, holes, and ions, which is able to be used as an electrolyte for a solar battery, and which does not have fluidity. In detail, examples thereof include a hole transporting material such as polycarbazole; an electron transporting material such as tetranitro fluorenone; a conductive polymer such as a polyol; a p-type semiconductor such as a polymer electrolyte where a liquid electrolyte is solidified by a polymer compound, copper iodide, or copper thiocyanate; electrolytes where a liquid electrolyte which includes a molten salt is solidified using fine particles; and the like.

The gel electrolytes are usually formed of electrolytes and gelling agents. Examples of the gelling agent include polymer gelling agents such as cross-linked polyacrylic resin derivatives, cross-linked polyacrylonitrile derivatives, polyalkylene oxide derivatives, silicone resins, and polymers which have a nitrogen-containing heterocyclic quaternary compound salt structure in the side chain.

The molten salt gel electrolytes are usually formed of a gel electrolyte described above and a normal temperature type molten salt. Examples of the normal temperature type molten salt include nitrogen-containing heterocyclic quaternary ammonium salt compounds such as pyridinium salts, and imidazolium salts.

Additives may be added as necessary to the electrolytes described above. The additives include nitrogen-containing aromatic compounds such as t-butylpyridine (TBP), and imidazole salts such as dimethyl propyl imidazole iodide (DMPII), methyl propyl imidazole iodide (MPII), ethyl methyl imidazole iodide (EMII), ethyl imidazole iodide (EII), and hexyl methyl imidazole iodide (HMII).

The electrolyte concentration in the electrolytes is preferably in a range of 0.001 mol/L or more to 1.5 mol/L or less, and particularly preferably in a range of 0.01 mol/L or more to 0.7 mol/L or less. However, in a case where the catalyst layer 15 is on the light receiving surface side in the photoelectric conversion element module 100, that is, in a case where the support substrate 17 is the light receiving surface, the incident light passes through the electrolytic solution to reach the photoelectric conversion layer 13 and the carriers are excited. Therefore, since there are cases where the performance of the solar battery decreases due to the electrolyte concentration, it is preferable to set the electrolyte concentration in consideration of this point.

### <Sealing Agent 18>

In detail, the sealing agent 18 is preferably a silicone resin, an epoxy resin, a polyisobutylene resin, a hot melt resin, a glass-based material, or the like, and may be set to a multi-layer structure using two or more types of these. For example, there are Model: 31X-101 manufactured by ThreeBond Holdings Co., Ltd., Model: 31X-088 manufactured by ThreeBond Holdings Co., Ltd., or general commercially available epoxy resins and the like. When forming the sealing agent 18, it is possible to form the sealing agent 18 using a dispenser in a case of using a silicone resin, an epoxy resin, or a glass frit and it is possible to form the sealing agent 18 by opening holes where the hot melt resin is patterned in a sheet shape in a case of using a hot melt resin.

### <Separation Layer 3>

The separation layer 3 is formed between the photoelectric conversion elements 1 which are connected in parallel and separates the photoelectric conversion elements 1 which is adjacent in the parallel direction inside the photoelectric conversion element module 100. The separation layer 3 is configured by a material which has pores. In detail, the separation layer 3 is preferably a non-woven fabric or the like formed of polyethylene, polypropylene, polyolefins, or the like. Pores are formed in the separation layer 3 such that it is possible for the carrier transporting material to pass through the separation layer 3 in a state where the pores are formed. The pores may be any type as long as it is possible for the carrier transporting material to pass through the pores, and the shape and dimensions thereof are not particularly limited.

In addition, the pores which are formed in the separation layer 3 are preferably closed due to an external load by heating or the like. The separation layer 3 is preferably formed from a material whose pores are closed due to an external load. For example, if problems occur in some of the photoelectric conversion elements 1 when the photoelectric conversion element module 100 is operated, heat is generated due to a large current passing therethrough and it is considered that the pores will close due to the heat.

When a problem occurs in some of the photoelectric conversion elements 1 which configure the photoelectric conversion element module 100, there are cases where a reverse current flows therethrough due to the photoelectric conversion element 1 where the problem occurs acting as a resistor. When heat is generated due to the reverse current, the carrier transporting material is deteriorated and all of the photoelectric conversion elements 1 which are connected in parallel are influenced. As a result, there is a concern that the performance of all of the photoelectric conversion elements 1 which are connected in parallel will be deteriorated and the characteristics of the photoelectric conversion element module 100 will be greatly degraded. In the photoelectric conversion element module 100 of the present embodiment, the separation layer 3 is formed of a material which has pores and it is possible to partially stop the deterioration of the carrier transporting material in a case where a problem occurs in the photoelectric conversion element 1 by using heat to close the pores in the separation layer 3. Accordingly, it is possible to suppress a decrease in the holding ratio of the characteristics of the photoelectric conversion element module 100.

Since the separation layer 3 is formed between the light transmitting substrate 11 and the support substrate 17, the thickness of the separation layer 3 is preferably less than the distance between the substrates. In addition, the separation layer 3 is in contact with the light transmitting substrate 11 and the support substrate 17. Due to this, since it is possible to inhibit the transporting of the electrolytes between the photoelectric conversion elements 1 after the pores are closed, it is possible to suppress further deterioration in the carrier transporting layer 14.

The adhesive which bonds the separation layer 3 and each of the substrates may be any material as long as the pores do not collapse in the bonding process and the pores are not filled in by the material permeating into the interior of the pores. In detail, examples include thermal bonding films which are fused at a lower temperature than the temperature at which the pores close, ultraviolet curing resins, and the like. In addition, the external load for closing the pores may be applied by any method where it is possible to heat the separation layer 3 such as heating by irradiation of light such as condensed light, infrared rays, or a laser, by a heater, or by high frequency induction.

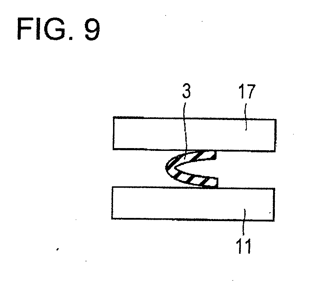

Fig. 7 is a cross-sectional diagram which illustrates a first example of the structure of the separation layer 3. Fig. 8 is a cross-sectional diagram which illustrates a second example of the structure of the separation layer 3. Fig. 9 is a cross-sectional diagram which illustrates a third example of the structure of the separation layer 3. When the portion where the separation layer 3 is bonded with each of the substrates is viewed in the projection direction of the cells, the bonded portions of each of the substrates may be formed in the same projection portion as shown in Fig. 7, or may be formed in different locations as shown in Fig. 8. In addition, it is also possible to form this portion as shown in Fig. 9.

In a case of the configuration shown in Fig. 7 where the bonded portion is formed in the same projection portion, the transmitting area of the separation layer 3 is limited to the area between the light transmitting substrate 11 and the support substrate 17. In contrast to this, when configured such that the bonded portion of each of the substrates is formed at a different location as shown in Fig. 8 and Fig. 9, since the transmitting area where it is possible to transmit the carrier transporting material is further increased, the transmission of the carrier transporting material is further facilitated and the manufacturing of the photoelectric conversion element module 100 is further facilitated.

More detailed description will be given of the present invention according to Examples; however, the present invention is not limited to these Examples. Here, in each of the Examples, the film thickness of each of the layers was measured using Surfcom 1400A (trade name) manufactured by Tokyo Seimitsu Co., Ltd. unless otherwise specified.

### Example 1

The manufacturing of the photoelectric conversion element module 100 using the photoelectric conversion element 1 shown in Fig. 5 was performed. Firstly, the light transmitting substrate 11 where the conductive film layer 12 which is a transparent conductive film is formed on the surface (manufactured by Nippon Sheet Glass Co., Ltd., trade name glass with an SnO₂ film attached, 50 mm vertically x 37 mm horizontally) was prepared. The conductive film layer 12 and the end section electrodes were cut by laser scribing the SnO₂ film on the surface of a conductive glass substrate and forming the scribe line 23 in parallel to the vertical direction. The scribe line 23 was formed at a total of four places at a position 9.5 mm from the left end of the light transmitting substrate 11 which is the support body and at 7 mm intervals therefrom. The width of the scribe line 23 which was formed was 60 µm.

Next, using a screen plate where a 5 mm x 8 mm pattern was lined up as three columns vertically and a three rows horizontally and a screen printing machine (manufactured by Newlong Seimitsu Kogyo Co., Ltd., model number: LS-150), commercially available titanium oxide paste (D/SP which is a trade name manufactured by Solaronix SA) was applied to the transparent electrode substrate, and levelling was performed for one hour at room temperature. After that, the obtained coated film was dried for 20 minutes in an oven set to 80°C and firing was further carried out for 60 minutes in air using a firing furnace set to 500°C (model number KDF P-100 manufactured by Denken Co., Ltd.). These coating and firing steps were repeated four times and a porous semiconductor film with a film thickness of 25 µm was prepared. One porous semiconductor film with a size of a width of 5 mm and a length of 8 mm was formed with a position at 6.9 mm from the left end of the glass substrate as the center, and nine porous semiconductor films with the same size were formed at intervals of 7 mm from the center of the porous semiconductor film in an orthogonal direction with respect to the scribe line and at intervals of 9 mm in the direction of the scribe line.

The porous insulation layers 25 were formed on the porous semiconductor layer according to the method for creating the porous semiconductor layer. One of the porous insulation layers 25 was formed with a size of a width of 5.6 mm and a length of 9 mm with a position at 6.9 mm from the left end of the light transmitting substrate 11 as the center and nine of the porous insulation layers 25 with the same size were formed at intervals of 7 mm from the center of the porous insulation layer 25 of the left end thereof in an orthogonal direction with respect to the scribe line 23 and at intervals of 9 mm in the direction of the scribe line 23.

Next, the catalyst layer 15 was obtained by depositing Pt on the porous insulation layer 25. Here, the size and the position of the catalyst layer 15 were set to the same as the porous semiconductor film.

Next, the counter conductive layers 16 were formed by a vapor deposition method. One of the counter conductive layers 16 was formed with a size of a width of 5.6 mm and a length of 8 mm with a position at 7.2 mm from the left end of the light transmitting substrate 11 as the center and nine of the counter conductive layers 16 with the same size were formed at intervals of 7 mm from the center of the porous insulation layer 25 of the left end thereof in an orthogonal direction with respect to the scribe line 23 and at intervals of 9 mm in the direction of the scribe line 23.

Next, after the laminated body described above was immersed for 120 hours at room temperature in a coloring dye adsorption solution prepared in advance, the laminated body was cleaned with ethanol, and the coloring dye was adsorbed to the porous semiconductor film by drying at approximately 60°C for approximately 5 minutes.

A coloring dye adsorption solution was prepared by dissolving the coloring dye of the above formula (2) (Ruthenium 620-1H3TBA which is a trade name manufactured by Solaronix SA) in a mixed solvent of acetonitrile and t-butanol at a 1:1 volume ratio so as to have a concentration of 4×10⁻⁴ mol/liter.

After that, a non-woven fabric made of polyethylene cut to a width of 0.3 mm and a length of 6 mm and interposed from above and below by thermal bonding films (Himilan) was installed between the laminated bodies formed along the scribe line 23 and the separation layers 3 were formed. Next, after an ultraviolet curing resin (31X-101 manufactured by ThreeBond Holdings Co., Ltd.) was applied using a dispenser (Ultrasaver manufactured by EFD Co., Ltd.) between the laminated bodies and at the periphery of the cells and bonding was carried out with a glass substrate 60 mm high and 30 mm long as the support substrate 17 which is the covering layer, the sealing agent 18 was formed by curing the photosensitive resin by irradiation of ultraviolet rays using an ultraviolet lamp (Novacure manufactured by EFD Co., Ltd.). Furthermore, each of the substrates and the non-woven fabric made of polyethylene were bonded by heating the thermal bonding film and the non-woven fabric portion made of polyethylene to 100°C.

After that, an electrolytic solution as a carrier transporting material was introduced using electrolytic solution introduction holes which were provided in advance in the support substrate 17 which was used as the covering layer, and the carrier transporting layer 14 was formed on all of the photoelectric conversion elements by the electrolytic solution permeating via the separation layers 3. The electrolytic solution introduction holes were only formed in the photoelectric conversion elements 1 at both ends of the photoelectric conversion elements 1 which were separated by the separation layers 3. That is, in the photoelectric conversion elements 1 other than at both ends, introduction holes for introducing the electrolytic solution were not formed in either of the light transmitting substrate 11 or the support substrate 17. After forming the carrier transporting layer 14, ultraviolet curable resin was applied onto the electrolytic solution introduction holes and cured and sealed by irradiation of ultraviolet rays in the same manner as for the sealing agent 18.

The electrolytic solution was obtained by adding and dissolving LiI (manufactured by Sigma-Aldrich Co., Ltd.) as a redox species such that the concentration was 0.1 mol/liter, I₂ (manufactured by Kishida Chemical Co., Ltd.) such that the concentration was 0.01 mol/liter, t-butyl pyridine (manufactured by Sigma-Aldrich Co., Ltd.) as an additive such that the concentration was 0.5 mol/liter, and dimethyl propyl imidazolium iodide (manufactured by Shikoku Chemicals Corp.) such that the concentration was 0.6 mol/liter, into acetonitrile as a solvent.

Furthermore, the separation layer 3 portion was heated to 150°C and the photoelectric conversion element module 100 was manufactured by using heat to dissolve the separation layers 3 so as to close the pores. In a case where the steps up to the introduction of the electrolytic solution to one photoelectric conversion element 1 and the forming of a sealing section onto the introduction holes were set as one step, it was possible to introduce the electrolytic solution (to form the carrier transporting layer) in the photoelectric conversion element module 100 of Example 1 by performing three steps.

Ag paste (trade name: Dotite, manufactured by Fujikura Kasei Co., Ltd.) was applied to serve as a collecting electrode section on the obtained module.

Next, after measuring the photoelectric conversion efficiency by emitting light (AM 1.5 Solar Simulator) with an intensity of 1 kW/m² onto the manufactured photoelectric conversion element module 100, exposure was carried out for 100 days outdoors. After that, the photoelectric conversion efficiency was measured under the same conditions and the holding ratio of the conversion efficiency before and after the exposure was confirmed.

### Example 2

A photoelectric conversion element module 100 of Example 2 was manufactured according to Example 1 except for that the material of the separation layers 3 of the photoelectric conversion element module 100 of Example 1 was changed to polyolefin.

### [Comparative Example 1]

A photoelectric conversion element module was manufactured according to Example 1 except for that a sealing section was formed instead of the separation layer 3 of the photoelectric conversion element module 100 of Example 1, electrolytic solution introduction holes were formed in each of the separated photoelectric conversion elements 1, and the electrolytic solution was introduced.

### [Comparative Example 2]

In the photoelectric conversion element module 100 of Example 2, a photoelectric conversion element module was manufactured according to Example 1 except for being manufactured without forming the separation layers 3.

The holding ratios of the conversion efficiency before and after the exposure for the photoelectric conversion element modules of Examples 1 and 2 and Comparative Examples 1 and 2 and the number of necessary steps for forming the carrier transporting layer are indicated in the following table.

**[Table 1]**

| | Pre-exposure Conversion Efficiency | Post-exposure Conversion Efficiency | Conversion Efficiency Holding Ratio | Necessary Number of Steps for Forming Carrier Transporting Layer |
|---|---|---|---|---|
| Example 1 | 6.72% | 6.05% | 90.1% | 3 Steps |
| Example 2 | 6.76% | 6.03% | 89.2% | 3 Steps |
| Comparative Example 1 | 6.77% | 6.12% | 90.5% | 9 Steps |
| Comparative Example 2 | 6.79% | 5.53% | 81.4% | 3 Steps |

In comparison with the photoelectric conversion element modules 100 of Examples 1 and 2, the photoelectric conversion element module of Comparative Example 1 was equivalent in the holding ratio of the conversion efficiency; however, the photoelectric conversion elements 1 were separated with the sealing section and not the separation layer 3 and it was necessary to form the carrier transporting layer for each photoelectric conversion element 1 respectively. Therefore, since the number of necessary steps in the forming of the carrier transporting layers greatly increased and the manufacturing process was complicated, there was a problem in that it was not possible to easily create the photoelectric conversion element module. On the other hand, for the photoelectric conversion element module of Comparative Example 2, the deterioration of the photoelectric conversion elements due to the separation layers 3 not being formed influenced the power generation efficiency of the photoelectric conversion element module as a whole. As a result, the holding ratio of the conversion efficiency after the exposure was greatly decreased in comparison with the photoelectric conversion element modules 100 of Examples 1 and 2. Accordingly, it was shown that it is possible to easily prepare and provide the photoelectric conversion element module 100 with excellent long-term reliability according to the method for manufacturing Examples 1 and 2.

Description was given above of embodiments of the present invention; however, the embodiments and Examples described herein are illustrative in all respects and should be considered as not limiting. The range of the present invention is shown by the scope of the claims and not the above description and it is intended that meanings equivalent to the scope of the claims and all changes within the scope of the claims be included.

### Reference Signs List

- 1: PHOTOELECTRIC CONVERSION ELEMENT
- 2: SEALING SECTION
- 3: SEPARATION LAYER
- 4: COLLECTING ELECTRODE
- 11: LIGHT TRANSMITTING SUBSTRATE
- 12: CONDUCTIVE FILM LAYER
- 13: PHOTOELECTRIC CONVERSION LAYER
- 14: CARRIER TRANSPORTING LAYER
- 15: CATALYST LAYER
- 16: COUNTER CONDUCTIVE LAYER
- 17: SUPPORT SUBSTRATE
- 18: SEALING AGENT
- 23: SCRIBE LINE
- 25: POROUS INSULATION LAYER
- 100: PHOTOELECTRIC CONVERSION ELEMENT MODULE

## Claims

1. A photoelectric conversion element module (100) comprising:
a plurality of photoelectric conversion elements (1) which are connected in series; and
a separation layer (3) which separates the adjacent photoelectric conversion elements (1) in a parallel direction,
wherein each of the photoelectric conversion elements (1) includes a light transmitting substrate (11) and a support substrate (17),
the light transmitting substrate (11) and the support substrate (17) are arranged to oppose each other,
each of the photoelectric conversion elements (1) further includes a conductive film layer (12), a photoelectric conversion layer (13) where a photosensitizing agent is adsorbed on a surface, a catalyst layer (15), a counter conductive layer (16), and a carrier transporting layer (14) which is formed of a carrier transporting material,
the conductive film layer (12), the photoelectric conversion layer (13), the catalyst layer (15), the counter conductive layer (16), and the carrier transporting layer (14) are arranged between the light transmitting substrate (11) and the support substrate (17),
each of the photoelectric conversion elements (1) further includes a sealing agent (18) which fixes the support substrate (17) to the light transmitting substrate (11), and
pores are formed in the separation layer (3).

2. The photoelectric conversion element module (100) according to Claim 1,
wherein the separation layer (3) is formed from a material whose pores are closed due to an external load.

3. The photoelectric conversion element module (100) according to Claim 1 or 2,
wherein the separation layer (3) is bonded with the light transmitting substrate (11) and the support substrate (17).

4. The photoelectric conversion element module (100) according to any one of Claims 1 to 3,
wherein, in at least one or more of the photoelectric conversion elements (1), an introduction hole for introducing the carrier transporting material is not formed in either of the light transmitting substrate (11) or the support substrate (17).

5. The photoelectric conversion element module (100) according to any one of Claims 1 to 4,
wherein each of the photoelectric conversion elements (1) includes a porous insulation layer (15) which is provided between the conductive film layer (12) and the counter conductive layer (16).

6. A method for manufacturing a photoelectric conversion element module (100) for manufacturing the photoelectric conversion element module (100) according to any one of Claims 1 to 5, comprising:
a step of forming a separation layer (3) where pores are formed; and
a step of forming a carrier transporting layer (14) by introducing a carrier transporting material via the separation layer (3).
